# EUROPEAN PATENT SPECIFICATION

(11) **EP 4 626 212 B1**
(45) Date of publication and mention of the grant of the patent: **07.10.2026**
(21) Application number: 25154890.5
(22) Date of filing: 30.01.2025
(51) Int. Cl.: H10N 60/01, H10N 60/12

(54) **METHOD FOR MANUFACTURING A JOSEPHSON DEVICE, JOSEPHSON DEVICE, AND QUBIT INCLUDING THE SAME**
VERFAHREN ZUR HERSTELLUNG EINES JOSEPHSON-BAUELEMENTS, JOSEPHSON-BAUELEMENT UND QUBIT MIT DEMSELBEN
PROCÉDÉ DE FABRICATION D'UN DISPOSITIF JOSEPHSON, DISPOSITIF JOSEPHSON ET BIT QUANTIQUE LE COMPRENANT

(30) Priority: 26.03.2024 JP 2024049527
(43) Date of publication of application: 01.10.2025
(73) Proprietor: FUJITSU LIMITED, Kawasaki-shi, Kanagawa 211-8588 (JP)
(72) Inventor: NAKAMURA, Makoto, Kawasaki-shi, 211-8588 (JP)
(74) Representative: Haseltine Lake Kempner LLP

(56) References cited:
- EP-A1- 4 471 830
- WO-A1-2023/139779
- CN-A- 114 525 579
- CN-A- 115 802 873
- US-A1- 2022 059 748
- ANDRIANOV V A ET AL: "The recombination of quasiparticles in x-ray superconducting tunnel detectors", MEASUREMENT TECHNIQUES, vol. 49, no. 8, August 2006 (2006-08-01), pages 830 - 838, XP019452746, DOI: 10.1007/S11018-006-0197-2
- FOROOZANI N ET AL: "Development of transmon qubits solely from optical lithography on 300 mm wafers", QUANTUM SCIENCE AND TECHNOLOGY, vol. 4, 025012, 20 March 2019 (2019-03-20), XP093290237, DOI: 10.1088/2058-9565/ab0ca8

## Description

### FIELD

The embodiments discussed herein are related to a Josephson device, a qubit including the Josephson device, and a method for manufacturing a Josephson device.

### BACKGROUND

Superconducting qubits using a Josephson device are being developed. The Josephson device has a structure in which an insulating film is interposed between a lower electrode and an upper electrode each including a superconducting material. It is known that the lower electrode and the upper electrode are formed of aluminum and/or titanium nitride.

Japanese National Publication of International Patent Application Nos. 2022-518112 and 2023-518348, and U.S. Patent Nos. 9515247 and 10256392, and U.S. Patent Application Publication No. 2022/0416392 are disclosed as related art.

Reference may be made to any of:
ANDRIANOV V A ET AL: "The recombination of quasiparticles in x-ray superconducting tunnel detectors", MEASUREMENT TECHNIQUES, vol. 49, no. 8, August 2006, pages 830-838;
CN 115 802 873 A, which relates to an ALD Josephson junction preparation method based on metal mask etching; and
WO 2023/139779 A1, which relates to a Josephson element, superconducting circuit, quantum computation device, and method for manufacturing the Josephson element.

Each of said three documents discloses a Josephson device with a lower electrode including at least a first layer of Ti or TiN and a second layer of superconducting Al, as well as a corresponding fabrication method. However, none of them teaches a (111) orientation of the Al layer.

### SUMMARY

### TECHNICAL PROBLEM

Current superconducting qubits have a large variation in characteristics. This is considered to be because a variation in characteristics of a Josephson device is large.

In one aspect, an object is to suppress a variation in characteristics of a Josephson device.

### SOLUTION TO PROBLEM

The present invention is defined by the independent claims, to which reference should now be made. Specific embodiments are defined in the dependent claims. According to an aspect of the invention, there is provided a method for manufacturing a Josephson device according to claim 1. According to another aspect of the invention, there is provided a Josephson device according to claim 5.

### ADVANTAGEOUS EFFECTS OF INVENTION

As one aspect, it is possible to suppress a variation in characteristics of a Josephson device.

### BRIEF DESCRIPTION OF DRAWINGS

FIG. 1A is a plan view of a Josephson device according to a first embodiment, and FIG. 1B is a cross-sectional view taken along line A-A in FIG. 1A;
FIG. 2A to FIG. 2D are cross-sectional views (part 1) illustrating a method for manufacturing the Josephson device according to the first embodiment;
FIG. 3A to FIG. 3D are cross-sectional views (part 2) illustrating the method for manufacturing the Josephson device according to the first embodiment;
FIG. 4A to FIG. 4C are cross-sectional views (part 3) illustrating the method for manufacturing the Josephson device according to the first embodiment;
FIG. 5A and FIG. 5B are respectively a schematic plan view and a schematic cross-sectional view in a case where crystal grains of aluminum are large, and FIG. 5C and FIG. 5D are respectively a schematic plan view and a schematic cross-sectional view in a case where crystal grains of aluminum are small;
FIG. 6A and FIG. 6B are cross-sectional views of Josephson devices according to a first modification example and a second modification example of the first embodiment, respectively;
FIG. 7 is a cross-sectional view of a Josephson device according to a second embodiment;
FIG. 8A and FIG. 8B are cross-sectional views illustrating a method for manufacturing the Josephson device according to the second embodiment;
FIG. 9A and FIG. 9B are cross-sectional views of Josephson devices according to a third embodiment and a modification example of the third embodiment, respectively;
FIG. 10 is a cross-sectional view of a Josephson device according to a fourth embodiment;
FIG. 11A to FIG. 11D are cross-sectional views (part 1) illustrating a method for manufacturing the Josephson device according to the fourth embodiment;
FIG. 12A to FIG. 12D are cross-sectional views (part 2) illustrating the method for manufacturing the Josephson device according to the fourth embodiment; and
FIG. 13 is a circuit diagram of a qubit according to a fifth embodiment.

### DESCRIPTION OF EMBODIMENTS

Hereinafter, embodiments of the present invention will be described with reference to the drawings.

### [First Embodiment]

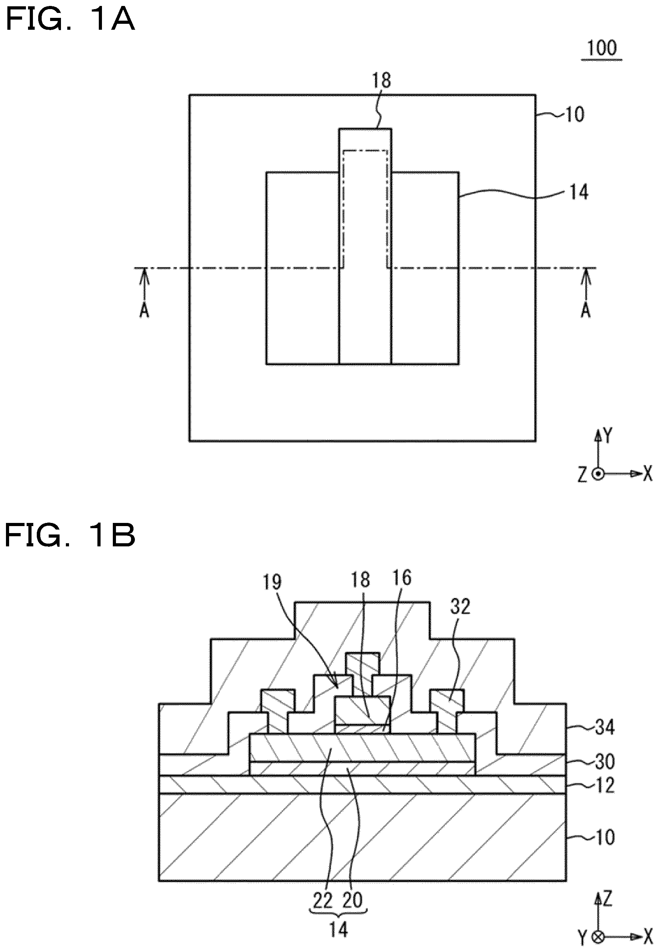

FIG. 1A is a plan view of a Josephson device 100 according to a first embodiment, and FIG. 1B is a cross-sectional view taken along line A-A in FIG. 1A. In FIG. 1A, a lower electrode 14 and an upper electrode 18 provided over a substrate 10 are illustrated, and the others are not illustrated. Directions parallel to an upper surface of the substrate 10 and orthogonal to each other are defined as an X-axis direction and a Y-axis direction. A direction perpendicular to the upper surface of the substrate 10 is defined as a Z-axis direction. As illustrated in FIG. 1A and FIG. 1B, in the Josephson device 100 according to the first embodiment, an insulating film 12 is provided over the substrate 10. The insulating film 12 has a thickness of, for example, 50 nm to 200 nm. The substrate 10 is, for example, a silicon (Si) substrate. The insulating film 12 is, for example, a silicon oxide (SiO₂) film. The substrate 10 and the insulating film 12 may be formed of other materials.

The lower electrode 14 is provided over the insulating film 12. The lower electrode 14 includes a first conductive film 20 and a second conductive film 22 provided in contact with an upper surface of the first conductive film 20. The first conductive film 20 includes at least one of a titanium (Ti) film and a titanium nitride (TiN) film. While a case where the first conductive film 20 is a Ti film or a TiN film is described as an example in the first embodiment, the first conductive film 20 may be a stacked film of a Ti film and a TiN film stacked over the Ti film. The second conductive film 22 is an aluminum (Al) film having a crystalline state in which a (111) orientation is dominant. In the present application, the Al film refers to a pure Al film having an Al purity of 99.0% or more. The first conductive film 20 has a thickness of, for example, 50 nm to 100 nm. The second conductive film 22 has a thickness of, for example, 100 nm to 300 nm. The second conductive film 22 is thicker than, for example, the first conductive film 20.

When the first conductive film 20 is a Ti film, it is preferable that the first conductive film 20 be a Ti film having a crystalline state in which a (002) orientation is dominant. When the first conductive film 20 is a TiN film, it is preferable that the first conductive film 20 be a TiN film having a crystalline state in which a (111) orientation is dominant. The orientation in the first conductive film 20 and the second conductive film 22 being dominant is a case where a degree of orientation is 80% or more, and may be 90% or more. The orientation of each film may be obtained by, for example, measurement by X-ray diffraction, measurement of a plane of each film by an electron microscope, or the like.

An insulating film 16 is provided over the lower electrode 14. The insulating film 16 is, for example, an aluminum oxide (Al₂O₃) film. The insulating film 16 has a thickness of, for example, 10 nm to 30 nm. The upper electrode 18 is provided over the insulating film 16. The insulating film 16 and the upper electrode 18 have substantially the same size and substantially the same shape in plan view. For example, the entire upper electrode 18 overlaps the entire insulating film 16, and both the insulating film 16 and the upper electrode 18 have a rectangular shape in plan view. The upper electrode 18 is, for example, an aluminum (Al) film. The upper electrode 18 has a thickness of, for example, 50 nm to 200 nm. A region where the lower electrode 14 and the upper electrode 18 overlap each other with the insulating film 16 interposed therebetween serves as a Josephson junction 19.

An insulating film 30 is provided to cover the lower electrode 14, the insulating film 16, and the upper electrode 18. The insulating film 30 is, for example, a silicon oxide (SiO₂) film. The insulating film 30 has a thickness of, for example, 400 nm to 600 nm. A wiring 32 that penetrates the insulating film 30 and is coupled to the lower electrode 14 and the upper electrode 18 is provided. The wiring 32 is, for example, a conductive film such as an aluminum (Al) film or an aluminum (Al) alloy film. A protective film 34 is provided over the insulating film 30 so as to cover the wiring 32. The protective film 34 is, for example, an insulating film such as a silicon oxide (SiO₂) film. The protective film 34 has a thickness of, for example, 400 nm to 600 nm.

### [Manufacturing Method]

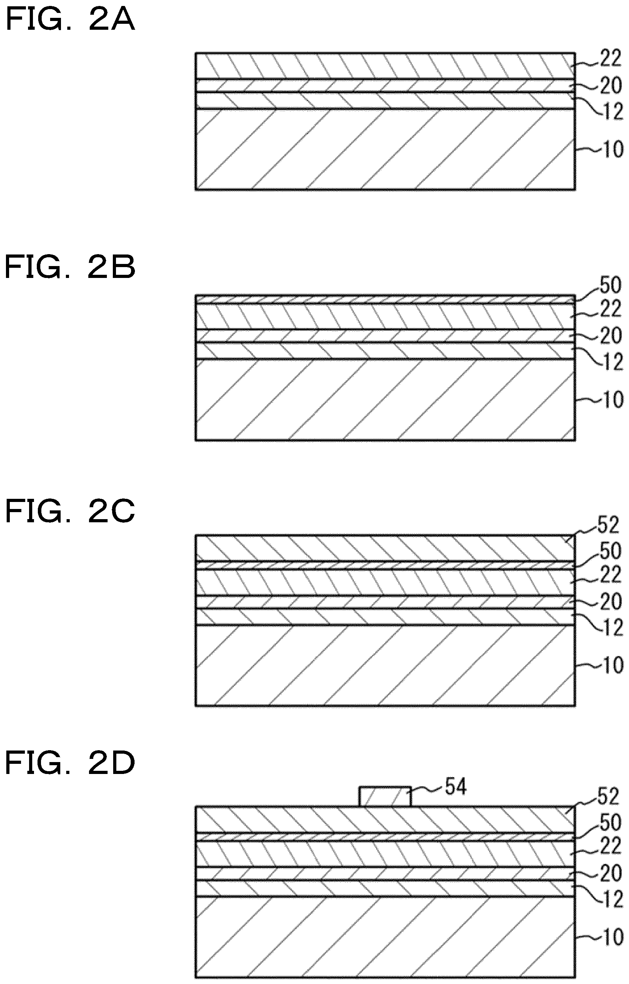

FIG. 2A to FIG. 4C are cross-sectional views illustrating a method for manufacturing the Josephson device 100 according to the first embodiment. As illustrated in FIG. 2A, the insulating film 12 is formed over the substrate 10 by using a sputtering method or a chemical vapor deposition (CVD) method. The first conductive film 20 and the second conductive film 22 are sequentially formed over the insulating film 12 by using a sputtering method. It is preferable that the first conductive film 20 and the second conductive film 22 be continuously formed in vacuum without breaking the vacuum. For example, the first conductive film 20 and the second conductive film 22 may be formed in a same chamber without breaking the vacuum, or may be individually formed in different chambers coupled to each other in the vacuum without breaking the vacuum. Before the second conductive film 22 is formed, reverse sputtering processing may be performed on the first conductive film 20. The first conductive film 20 is a Ti film or a TiN film. The second conductive film 22 is an Al film.

When a Ti film is formed as the first conductive film 20 by a sputtering method, the Ti film is formed by using a Ti target and argon (Ar) gas under conditions of, for example, a RF power: 7.0 kW, a gas pressure: 1 × 10⁻² Pa, and a substrate temperature: 523 K. By forming a Ti film by sputtering under conditions where the substrate temperature is as low as 573 K or lower, a Ti film having a crystalline state in which a (002) orientation is dominant is formed (see, for example, "Influence of Sputtering Conditions on the Microstructure of Titanium Thin Films Grown on a Silicon Substrate", Gen SASAKI and four others, Journal of the Japan Institute of Metals and Materials, 2003, Vol. 67, No. 12, pp. 703 to 707). Hereinafter, this document may be referred to as Document 1.

When a TiN film is formed as the first conductive film 20 by a sputtering method, the TiN film is formed by using a Ti target, Ar gas, and nitrogen (N₂) gas under conditions of, for example, a RF power: 300 W, an ultimate pressure: 1 × 10⁻⁴ Pa, an N₂ partial pressure: 2 to 6 × 10⁻³ Pa, and an Ar partial pressure: 0.4 Pa (see, for example, "Effect of Target Materials on Deposition of Nitride Films by rf Reactive Magnetron Sputtering", Shozo INOUE and two others, Journal of the Japan Society for Precision Engineering, 2003, Vol. 69, No. 7, pp. 976 to 980). By setting the N₂ partial pressure to be equal to or higher than 2 × 10⁻³ Pa, a TiN film having a crystalline state in which a (111) orientation is dominant is formed (see, for example, "Influence of Nitrogen Gas Partial Pressure on the Properties of TiN Deposited by Reactive Sputter Deposition", Ikuya NISHIMURA and two others, Journal of The Surface Finishing Society of Japan, 1992, Vol. 43, No. 6, pp. 584 to 588).

As the second conductive film 22, an Al film is formed by sputtering under general conditions. For example, the Al film is formed by using an Al target and Ar gas under the conditions of a RF power: 10 W to 80 W and a gas pressure: 0.4 Pa by sputtering. Since the second conductive film 22 is formed over the upper surface of the first conductive film 20 which is a Ti film or a TiN film, an Al film having a crystalline state in which a (111) orientation is dominant is formed. For example, when the Ti film has a (002) orientation and the TiN film has a (111) orientation, the Al film having a (111) orientation is likely to be formed (see, for example, Document 1 described above). It is considered that the reason why the Al film having a (111) orientation is likely to be formed by forming the Al film over the Ti film having a (002) orientation or the TiN film having a (111) orientation is that an interplanar spacing between a (002) plane of Ti and a (111) plane of TiN is close to an interplanar spacing of a (111) plane of Al.

As illustrated in FIG. 2B, an intermediate insulating film 50 is formed over the second conductive film 22 by using, for example, an atomic layer deposition (ALD) method. The intermediate insulating film 50 is, for example, an aluminum oxide (Al₂O₃) film. The intermediate insulating film 50 has a thickness of, for example, 10 nm to 30 nm. The intermediate insulating film 50 may be formed by using anodic oxidation instead of the ALD method. By forming the intermediate insulating film 50 by using the ALD method, a film thickness of the intermediate insulating film 50 may be favorably controlled.

As illustrated in FIG. 2C, a superconducting film 52 is formed over the intermediate insulating film 50 by using, for example, a sputtering method or a vapor deposition method. The superconducting film 52 is, for example, an aluminum (Al) film. The superconducting film 52 has a thickness of, for example, 50 nm to 200 nm.

As illustrated in FIG. 2D, a resist mask layer 54 that covers a region where the upper electrode 18 is to be formed is formed over the superconducting film 52.

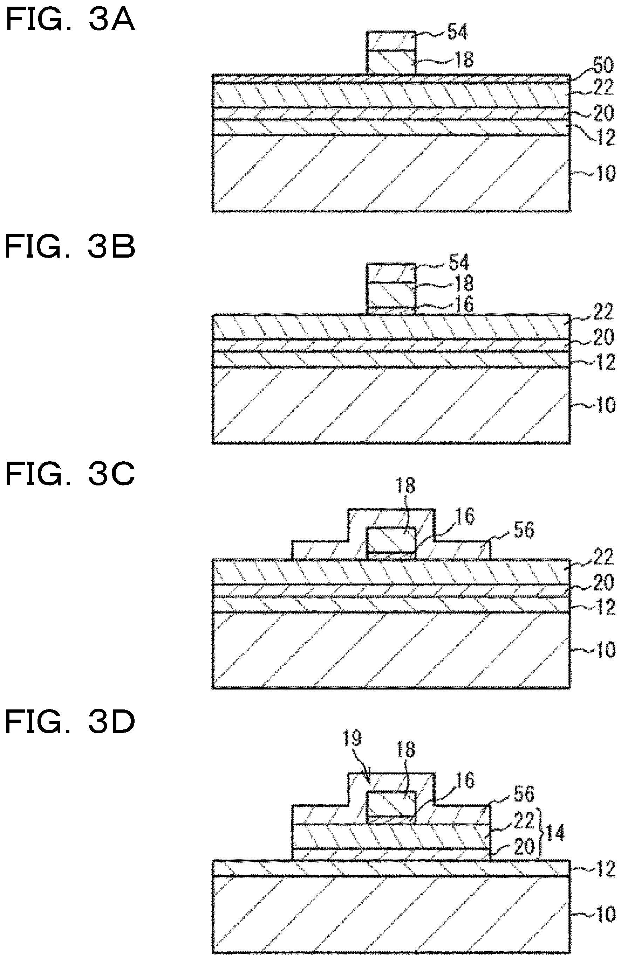

As illustrated in FIG. 3A, the superconducting film 52 is etched by reactive ion etching using, for example, a chlorine-based gas by using the resist mask layer 54 as a mask. Consequently, the upper electrode 18 made of the superconducting film 52 is formed.

As illustrated in FIG. 3B, the intermediate insulating film 50 is etched by, for example, an ion milling method by using the resist mask layer 54 as a mask. Consequently, the insulating film 16 having substantially the same size and substantially the same shape as the upper electrode 18 in plan view is formed to overlap the upper electrode 18 below the upper electrode 18.

As illustrated in FIG. 3C, after the resist mask layer 54 is removed, a resist mask layer 56 that covers a region where the lower electrode 14 is to be formed is formed.

As illustrated in FIG. 3D, the second conductive film 22 and the first conductive film 20 are etched by reactive ion etching using, for example, a chlorine-based gas by using the resist mask layer 56 as a mask. Consequently, the lower electrode 14 which is a stacked film of the first conductive film 20 and the second conductive film 22 is formed. A region where the lower electrode 14 and the upper electrode 18 overlap each other with the insulating film 16 interposed therebetween serves as the Josephson junction 19.

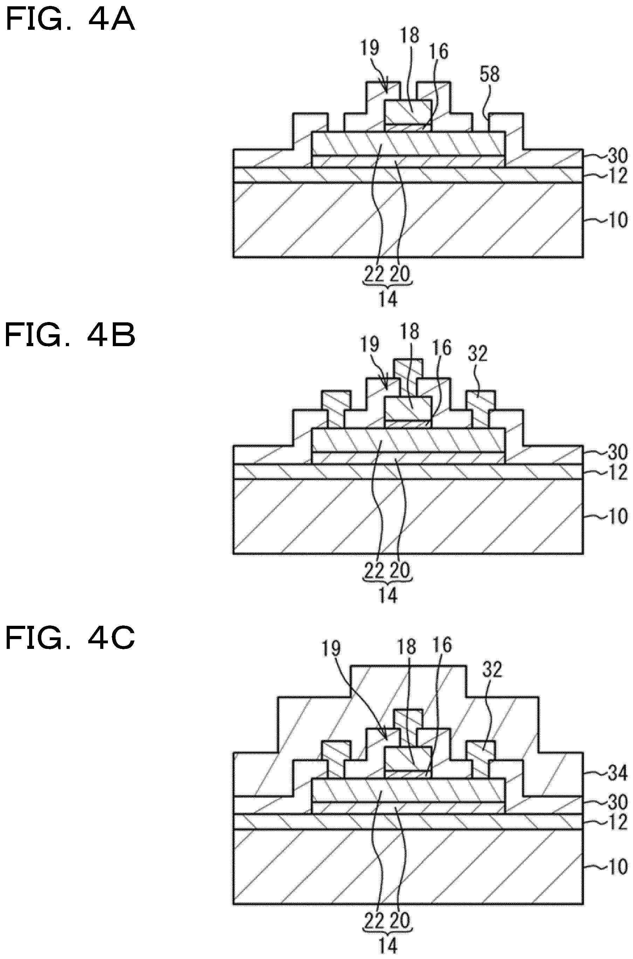

As illustrated in FIG. 4A, the insulating film 30 that covers the lower electrode 14, the insulating film 16, and the upper electrode 18 is formed over the substrate 10. The insulating film 30 is formed by using, for example, a CVD method. After that, through-holes 58 that penetrate the insulating film 30 are formed over the lower electrode 14 and the upper electrode 18. The through-holes 58 are formed by etching the insulating film 30 by reactive ion etching using, for example, a fluorine-based gas.

As illustrated in FIG. 4B, the wiring 32 that is embedded in the through-holes 58 and is coupled to the lower electrode 14 and the upper electrode 18 is formed. The wiring 32 is formed by forming a metal film (for example, an Al film or an Al-alloy film) so as to be embedded in the through-holes 58 by using, for example, a sputtering method, and then patterning the metal film by, for example, a photolithography method and an etching method.

As illustrated in FIG. 4C, the protective film 34 is formed over the insulating film 30 so as to cover the wiring 32. The protective film 34 is formed by using, for example, a CVD method.

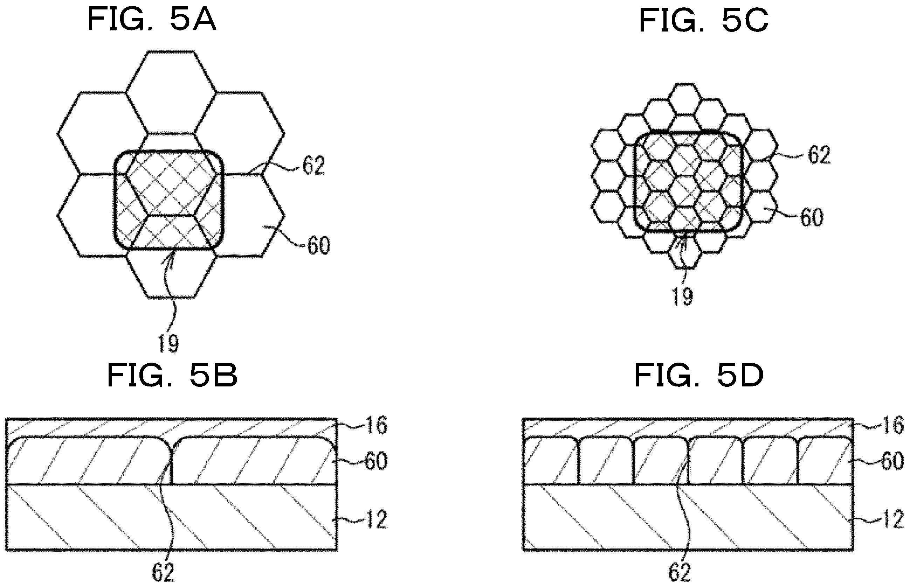

According to the first embodiment, as illustrated in FIG. 1B, the lower electrode 14 includes the first conductive film 20 including at least one of a Ti film and a TiN film, and the second conductive film 22 that is provided over the upper surface of the first conductive film 20 and includes Al having a (111) orientation. With the second conductive film 22 including Al having the (111) orientation, a surface with a high crystal density appears at the upper surface of the lower electrode 14, and the crystallinity at the upper surface of the lower electrode 14 is stabilized. Consequently, the insulating film 16 is likely to be stably formed over the upper surface of the lower electrode 14, and the film thickness of the insulating film 16 is stabilized. Since natural oxidation of the upper surface of the lower electrode 14 is less likely to proceed, the film thickness of the insulating film 16 is stabilized also in this respect. By forming the second conductive film 22 over the upper surface of the first conductive film (Ti film or TiN film), a crystal grain size of Al is reduced, for example, as compared with a case where the second conductive film 22 is formed over an upper surface of a SiO₂ film. This is because, since the crystal grain sizes of Ti and TiN are small, Al formed thereover is affected by the crystal of an underlying layer, and the crystal grain size of Al is also reduced. Consequently, a variation in a ratio of an area occupied by crystal grain boundaries of Al in the Josephson junction 19 is reduced. This will be described with reference to FIG. 5A to FIG. 5D.

FIG. 5A and FIG. 5B are respectively a schematic plan view and a schematic cross-sectional view in a case where crystal grains of aluminum are large, and FIG. 5C and FIG. 5D are respectively a schematic plan view and a schematic cross-sectional view in a case where crystal grains of aluminum are small. In a case where crystal grains 60 of Al are large as illustrated in FIG. 5A, a variation in a formation position of the Josephson junction 19 causes a variation in a ratio of an area occupied by crystal grain boundaries 62 of Al in the Josephson junction 19. On the other hand, in a case where the crystal grains 60 are small as illustrated in FIG. 5C, even when the formation position of the Josephson junction 19 varies, the variation in the ratio of the area occupied by the crystal grain boundaries 62 in the Josephson junction 19 is suppressed to be small. In a case where the crystal grains 60 are large as illustrated in FIG. 5B, a recess at the crystal grain boundary 62 is large. In contrast, in a case where the crystal grains 60 are small as illustrated in FIG. 5D, the recess at the crystal grain boundary 62 is small. From these, when the crystal grains 60 are large, the variation in the film thickness of the insulating film 16 formed over the lower electrode 14 increases, but when the crystal grains 60 are small, the variation in the film thickness of the insulating film 16 is suppressed to be small.

With the second conductive film 22 including Al having a (111) orientation in the first embodiment as described above, the upper surface of the lower electrode 14 is a surface with a high crystal density, and thus the film thickness of the insulating film 16 formed over the lower electrode 14 is stabilized. By forming the second conductive film 22 over the upper surface of the first conductive film 20 which is a Ti film or a TiN film, the crystal grains 60 of Al become smaller, and thus the film thickness of the insulating film 16 is stabilized. Since the variation in the film thickness of the insulating film 16 is suppressed as described above, the variation in characteristics of the Josephson device may be suppressed.

According to the manufacturing method of the first embodiment, as illustrated in FIG. 2A, the first conductive film 20 including at least one of a Ti film and a TiN film and the second conductive film 22 including Al are formed by using a sputtering method. As illustrated in FIG. 3D, the lower electrode 14 including the first conductive film 20 and the second conductive film 22 provided over the upper surface of the first conductive film 20 is formed. The insulating film 16 is formed over the lower electrode 14. The upper electrode 18 is formed so as to have a region (Josephson junction 19) overlapping the lower electrode 14 via the insulating film 16. When, for example, film formation is performed by using a vapor deposition method, the first conductive film 20 including at least one of a Ti film and a TiN film is formed by a sputtering method and only the second conductive film 22 is formed by the vapor deposition method because it is difficult to form a film of Ti, which is a high-melting-point metal, by the vapor deposition method. In this case, the second conductive film 22 is formed over the first conductive film 20 in a state where a natural oxide film is formed over the upper surface of the first conductive film 20. When the second conductive film 22 is formed over the natural oxide film, the second conductive film 22 including Al having a (111) orientation is less likely to be formed. On the other hand, by forming the first conductive film 20 and the second conductive film 22 by a sputtering method as in the first embodiment, the second conductive film 22 may be continuously formed in vacuum following the first conductive film 20. Consequently, the second conductive film 22 is formed over the upper surface of the first conductive film 20 in a state where the natural oxide film is not formed over the upper surface of the first conductive film 20. In this case, the second conductive film 22 including Al having a (111) orientation may be formed. The crystal grain size of Al in the second conductive film 22 is reduced. Consequently, as described above, the film thickness of the insulating film 16 may be stabilized, and the variation in characteristics of the Josephson device 100 may be suppressed. By forming the first conductive film 20 and the second conductive film 22 by a sputtering method, both the first conductive film 20 and the second conductive film 22 are formed as dense films.

In the manufacturing method of the first embodiment, as illustrated in FIG. 2A, the first conductive film 20 and the second conductive film 22 are formed by using a sputtering method. As illustrated in FIG. 2B, the intermediate insulating film 50 is formed over the second conductive film 22. As illustrated in FIG. 2C, the superconducting film 52 including a superconducting material is formed over the intermediate insulating film 50. As illustrated in FIG. 3A, the upper electrode 18 is formed by patterning the superconducting film 52 by using the resist mask layer 54 (first mask layer) formed over the superconducting film 52 as a mask. As illustrated in FIG. 3B, the insulating film 16 is formed by patterning the intermediate insulating film 50 by using the resist mask layer 54 as a mask. As illustrated in FIG. 3D, the lower electrode 14 is formed by patterning the second conductive film 22 and the first conductive film 20 by using, as a mask, the resist mask layer 56 (second mask layer) formed over the second conductive film 22 so as to cover the upper electrode 18 and the insulating film 16. Consequently, a Josephson device in which a variation in characteristics is suppressed may be easily formed.

In the first embodiment, the first conductive film 20 is preferably a TiN film having a (111) orientation. In this case, the second conductive film 22 including Al having a (111) orientation is likely to be formed.

### [Modification Examples]

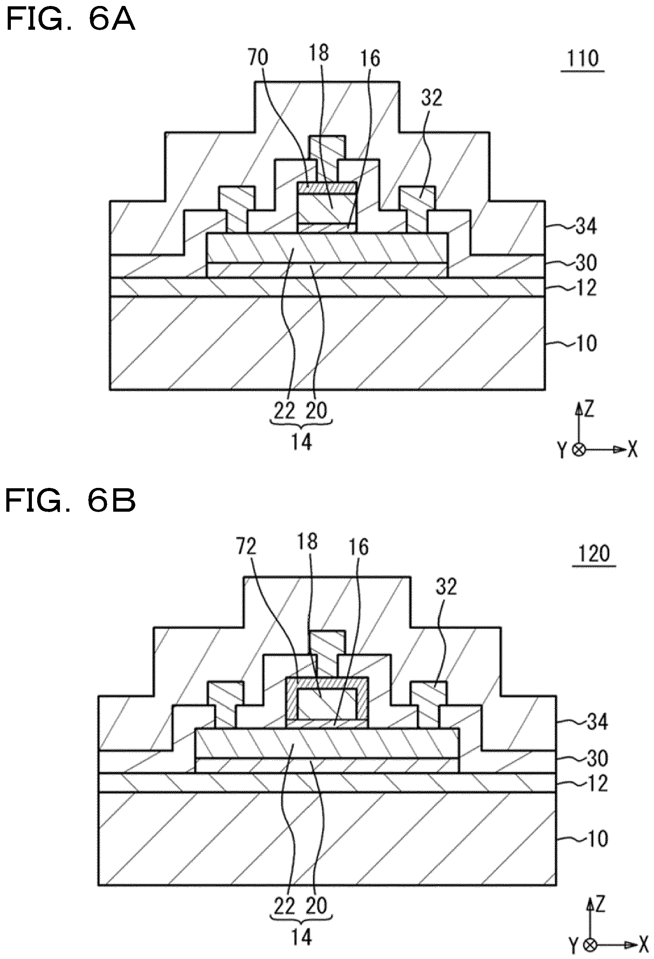

FIG. 6A is a cross-sectional view of a Josephson device 110 according to a first modification example of the first embodiment. As illustrated in FIG. 6A, in the first modification example of the first embodiment, a coating film 70 is provided to cover the upper surface of the upper electrode 18. The coating film 70 is, for example, a TiN film or a silicon nitride (SiN) film. The coating film 70 is formed instead of the resist mask layer 54 in FIG. 2D, and is a film that is left without being removed after the superconducting film 52 and the intermediate insulating film 50 are patterned by using the coating film 70 as a mask. Since other configurations are the same as those of the first embodiment, description is omitted. Since the intermediate insulating film 50 is etched by an ion milling method, when the resist mask layer 54 is used, it is considered that the resist mask layer 54 may be removed and the upper electrode 18 may be etched. By using the coating film 70 which is a TiN film or a SiN film instead of the resist mask layer 54, the coating film 70 is less likely to be etched than the resist mask layer 54 in the ion milling method, and thus it is possible to suppress the upper electrode 18 from being etched.

FIG. 6B is a cross-sectional view of a Josephson device 120 according to a second modification example of the first embodiment. As illustrated in FIG. 6B, in the second modification example of the first embodiment, the insulating film 16 is larger than the upper electrode 18 in plan view, and a coating film 72 is provided over the insulating film 16 so as to cover the upper surface and the side surfaces of the upper electrode 18. In plan view, the coating film 72 has substantially the same size as the insulating film 16. Since other configurations are the same as those of the first embodiment, description is omitted.

### [Second Embodiment]

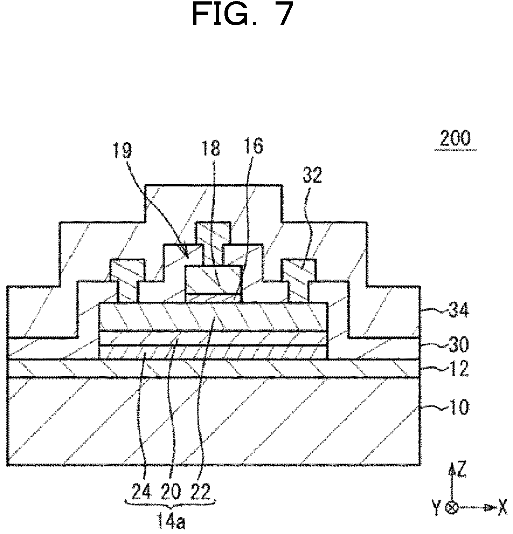

FIG. 7 is a cross-sectional view of a Josephson device 200 according to a second embodiment. As illustrated in FIG. 7, in the second embodiment, a lower electrode 14a includes a third conductive film 24 located between the insulating film 12 and the first conductive film 20. In the lower electrode 14a, the first conductive film 20 is a TiN film provided over an upper surface of the third conductive film 24. The first conductive film 20 is, for example, a TiN film having a crystalline state in which a (111) orientation is dominant. The third conductive film 24 is a Ti film. The third conductive film 24 is, for example, a Ti film having a crystalline state in which a (002) orientation is dominant. Since other configurations are the same as those of the first embodiment, description is omitted.

### [Manufacturing Method]

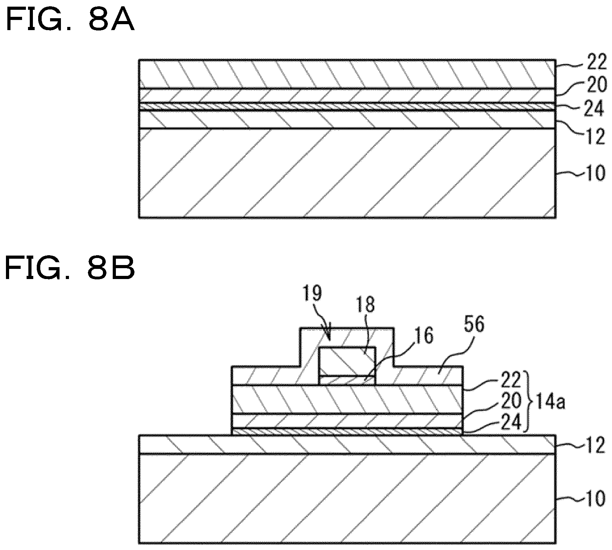

FIG. 8A and FIG. 8B are cross-sectional views illustrating a method for manufacturing the Josephson device 200 according to the second embodiment. As illustrated in FIG. 8A, the insulating film 12 is formed over the substrate 10 by a sputtering method or a CVD method. The third conductive film 24, the first conductive film 20, and the second conductive film 22 are sequentially formed over the insulating film 12 by using a sputtering method. It is preferable that the third conductive film 24, the first conductive film 20, and the second conductive film 22 be continuously formed in vacuum without breaking the vacuum. The third conductive film 24 is a Ti film. The first conductive film 20 is a TiN film. The second conductive film 22 is an Al film.

The third conductive film 24 is formed by using a Ti target and Ar gas under conditions of, for example, a RF power: 7.0 kW, a gas pressure: 1 × 10⁻² Pa, and a substrate temperature: 523 K by sputtering. Consequently, as described above, a Ti film having a crystalline state in which a (002) orientation is dominant is formed. The first conductive film 20 is formed by using a Ti target, Ar gas, and N₂ gas under conditions of, for example, a RF power: 300 W, an ultimate pressure: 1 × 10⁻⁴ Pa, a N₂ partial pressure: 2 to 6 × 10⁻³ Pa, and an Ar partial pressure: 0.4 Pa by sputtering. Consequently, as described above, a TiN film having a crystalline state in which a (111) orientation is dominant is formed. Since an interplanar spacing of a (111) plane of TiN is close to an interplanar spacing of a (002) plane of Ti, a TiN film having a (111) orientation is more likely to be formed by forming a TiN film over the (002) plane of Ti. As the second conductive film 22, an Al film is formed by sputtering under general conditions. For example, the Al film is formed by using an Al target and Ar gas under the conditions of a RF power: 10 W to 80 W and a gas pressure: 0.4 Pa by sputtering. Since an interplanar spacing of a (111) plane of Al and the interplanar spacing of the (111) plane of TiN are close to each other, the second conductive film 22 including Al having a (111) orientation is likely to be formed by forming an Al film over the (111) plane of TiN.

After that, the same processes as those illustrated in FIG. 2B to FIG. 3C of the first embodiment are performed. Next, as illustrated in FIG. 8B, the second conductive film 22, the first conductive film 20, and the third conductive film 24 are etched by reactive ion etching using, for example, a chlorine-based gas by using the resist mask layer 56 as a mask. Consequently, the lower electrode 14a, which is a stacked film of the third conductive film 24, the first conductive film 20, and the second conductive film 22, is formed. The region where the lower electrode 14a and the upper electrode 18 overlap each other with the insulating film 16 interposed therebetween serves as the Josephson junction 19.

After that, the same processes as those of FIG. 4A to FIG. 4C of the first embodiment are performed.

According to the second embodiment, the first conductive film 20 is a TiN film having a (111) orientation. In this case, the second conductive film 22 including Al having a (111) orientation is likely to be formed.

In the second embodiment, the lower electrode 14a includes the third conductive film 24, which is a Ti film having a (002) orientation, provided between the insulating film 12 and the first conductive film 20. The first conductive film 20 is provided over the upper surface of the third conductive film 24. By providing the third conductive film 24, which is a Ti film, between the first conductive film 20, which is a TiN film, and the substrate 10, it is possible to improve adhesion between the lower electrode 14a and the substrate 10. With the third conductive film 24 being a Ti film having a (002) orientation, the first conductive film 20 which is a TiN film having a (111) orientation is likely to be formed. With the first conductive film 20 being a TiN film having a (111) orientation, the second conductive film 22 which is an Al film having a (111) orientation is likely to be formed. Consequently, the film thickness of the insulating film 16 is stabilized, and the variation in characteristics of the Josephson device is suppressed.

Also in the second embodiment, as in the first modification example and the second modification example of the first embodiment, the coating film 70 may be provided over the upper surface of the upper electrode 18, and the coating film 72 may be provided over the side surfaces and the upper surface of the upper electrode 18.

### [Third Embodiment]

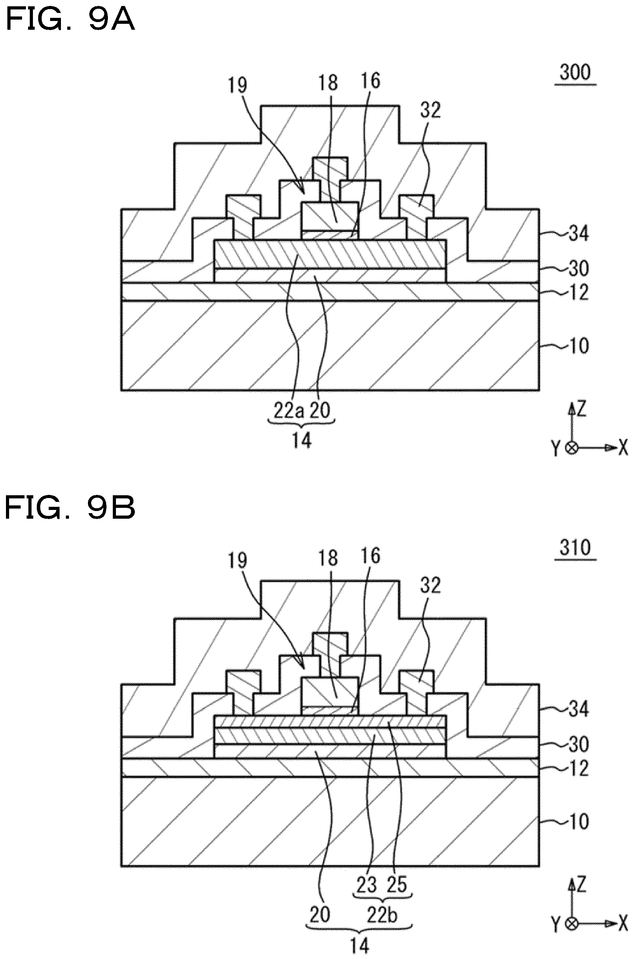

FIG. 9A is a cross-sectional view of a Josephson device 300 according to a third embodiment. As illustrated in FIG. 9A, in the third embodiment, the lower electrode 14 includes the first conductive film 20 and a second conductive film 22a. The second conductive film 22a is an Al-alloy film in which another element is added to Al. Examples of the element to be added include at least one kind of copper (Cu), palladium (Pd), magnesium (Mg), and silicon (Si). Similarly to the second conductive film 22, the second conductive film 22a includes Al having a (111) orientation. Since other configurations are the same as those of the first embodiment, description is omitted. The Josephson device 300 according to the third embodiment is formed by the same method as that in FIG. 2A to FIG. 4C of the first embodiment except that the second conductive film 22a is formed instead of the second conductive film 22.

### [Modification Example]

FIG. 9B is a cross-sectional view of a Josephson device 310 according to a modification example of the third embodiment. As illustrated in FIG. 9B, in the modification example of the third embodiment, the lower electrode 14 includes the first conductive film 20 and a second conductive film 22b. The second conductive film 22b includes a first film 23 which is an Al-alloy film in which another element (for example, at least one kind of Cu, Pd, Mg, and Si) is added to Al, and a second film 25 which is an Al film provided between the first film 23 and the insulating film 16. Both the first film 23 and the second film 25 include Al having a (111) orientation. Since other configurations are the same as those of the first embodiment, description is omitted. The Josephson device 310 according to the modification example of the third embodiment is formed by the same method as that in FIG. 2A to FIG. 4C of the first embodiment except that the second conductive film 22b is formed instead of the second conductive film 22.

According to the third embodiment and the modification example thereof, the second conductive films 22a and 22b include the Al-alloy film in which another element is added to Al. With the second conductive films 22a and 22b including Al having a (111) orientation in this case as well, the film thickness of the insulating film 16 is stabilized and the variation in characteristics of the Josephson device is suppressed as in the first embodiment. With the second conductive films 22a and 22b including the Al-alloy film, the crystal grain size of the second conductive films 22a and 22b may be further reduced. Consequently, the film thickness of the insulating film 16 may be further stabilized, and the variation in characteristics of the Josephson device may be suppressed. From the viewpoint of reducing the crystal grain size, the amount of another element to be added is preferably 0.3 wt% or more, more preferably 0.5 wt% or more, and still more preferably 1.0 wt% or more. From the viewpoint of suppressing deterioration in characteristics due to scattering of electrons or the like, the amount of another element to be added is preferably 4.0 wt% or less, more preferably 3.0 wt% or less, and still more preferably 2.0 wt% or less.

In the modification example of the third embodiment, the second conductive film 22b includes the first film 23 which is an Al-alloy film and the second film 25 which is an Al film provided between the first film 23 and the insulating film 16. With the first film 23 being an Al-alloy film, the crystal grain size of the second conductive film 22b may be reduced. When the insulating film 16 is formed over the Al-alloy film, deterioration in characteristics is concerned. However, in the modification example of the third embodiment, since the insulating film 16 is formed over the second film 25 which is an Al film, deterioration in characteristics may be suppressed.

In the third embodiment and the modification example thereof, as in the first modification example and the second modification example of the first embodiment, the coating film 70 may be provided over the upper surface of the upper electrode 18, and the coating film 72 may be provided over the side surfaces and the upper surface of the upper electrode 18. As in the second embodiment, the third conductive film 24 may be provided between the insulating film 12 and the first conductive film 20.

### [Fourth Embodiment]

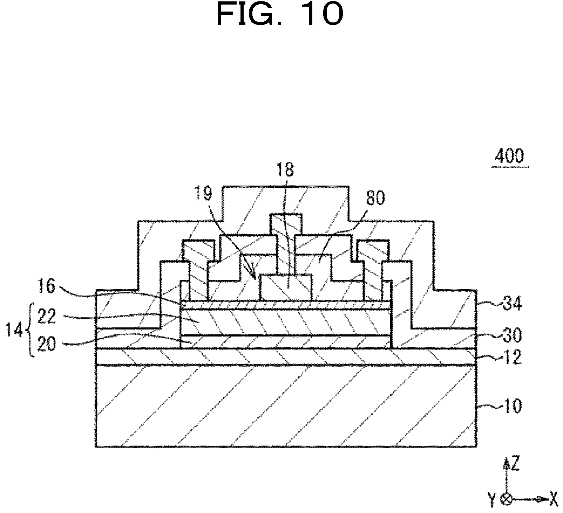

FIG. 10 is a cross-sectional view of a Josephson device 400 according to a fourth embodiment. As illustrated in FIG. 10, in the fourth embodiment, the insulating film 16 has substantially the same size and substantially the same shape as the lower electrode 14 in plan view and is provided over the entire surface of the lower electrode 14. The upper electrode 18 is provided only over a part of the insulating film 16. A coating film 80 that covers the upper electrode 18 is provided over the insulating film 16. The coating film 80 is, for example, a TiN film or a SiN film. Since other configurations are the same as those of the first embodiment, description is omitted.

### [Manufacturing Method]

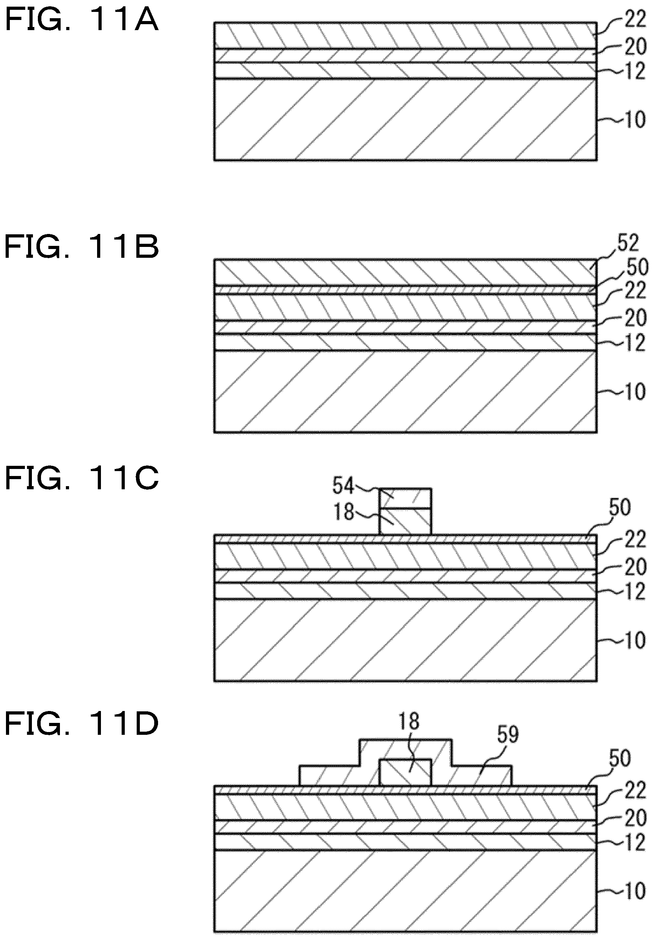

FIG. 11A to FIG. 12D are cross-sectional views illustrating a method for manufacturing the Josephson device 400 according to the fourth embodiment. As illustrated in FIG. 11A, the insulating film 12 is formed over the substrate 10 by using a sputtering method or a CVD method. The first conductive film 20 and the second conductive film 22 are sequentially formed over the insulating film 12 by using a sputtering method. The first conductive film 20 and the second conductive film 22 are formed under the conditions described in FIG. 2A of the first embodiment. Consequently, the first conductive film 20 which is a Ti film having a crystalline state in which a (002) orientation is dominant or a TiN film having a crystalline state in which a (111) orientation is dominant is formed. The second conductive film 22, which is an Al film having a crystalline state in which a (111) orientation is dominant, is formed over the upper surface of the first conductive film 20.

As illustrated in FIG. 11B, the intermediate insulating film 50 is formed over the second conductive film 22 by using, for example, an ALD method. The superconducting film 52 is formed over the intermediate insulating film 50 by using, for example, a sputtering method or a vapor deposition method.

As illustrated in FIG. 11C, the resist mask layer 54 that covers a region where the upper electrode 18 is to be formed is formed over the superconducting film 52. The superconducting film 52 is etched by, for example, reactive ion etching by using the resist mask layer 54 as a mask. Consequently, the upper electrode 18 made of the superconducting film 52 is formed.

As illustrated in FIG. 11D, after the resist mask layer 54 is removed, a hard mask layer 59 that covers a region where the lower electrode 14 is to be formed is formed. The hard mask layer 59 is formed of, for example, TiN or SiN.

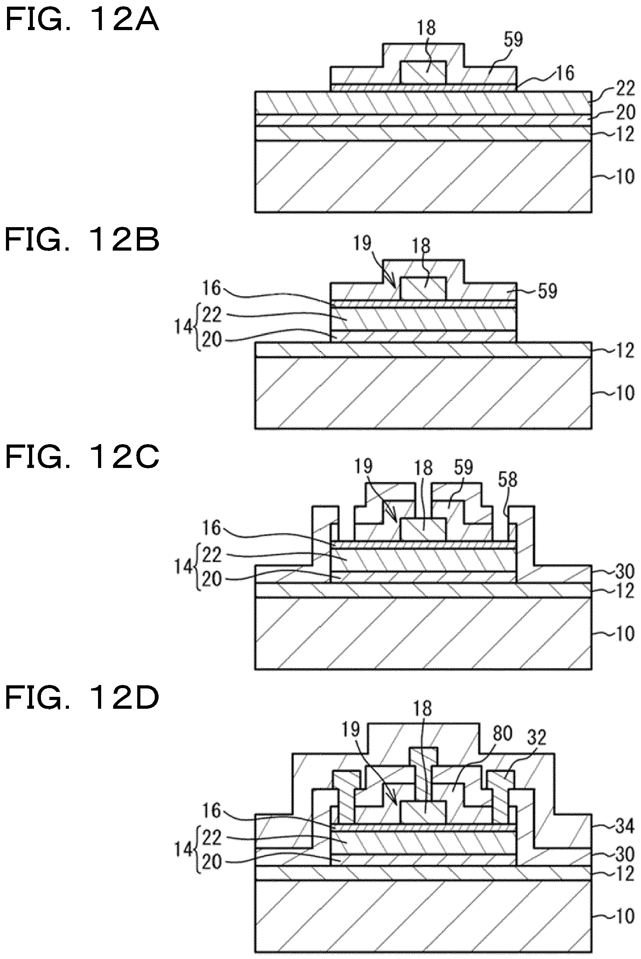

As illustrated in FIG. 12A, the intermediate insulating film 50 is etched by, for example, an ion milling method by using the hard mask layer 59 as a mask. Consequently, the insulating film 16 overlapping the upper electrode 18 is formed below the upper electrode 18. With the ion milling method using the hard mask layer 59, the hard mask layer 59 is less likely to be removed, and etching of the upper electrode 18 and the intermediate insulating film 50 covered with the hard mask layer 59 is suppressed.

As illustrated in FIG. 12B, the second conductive film 22 and the first conductive film 20 are etched by, for example, reactive ion etching by using the hard mask layer 59 as a mask. Consequently, the lower electrode 14 which is a stacked film of the first conductive film 20 and the second conductive film 22 is formed. When seen in plan view, the lower electrode 14 has substantially the same size and substantially the same shape as the insulating film 16. A region where the lower electrode 14 and the upper electrode 18 overlap each other with the insulating film 16 interposed therebetween serves as the Josephson junction 19.

As illustrated in FIG. 12C, the insulating film 30 that covers the lower electrode 14, the insulating film 16, the upper electrode 18, and the hard mask layer 59 is formed over the substrate 10. After that, the through-holes 58 that penetrate the insulating film 30 and the hard mask layer 59 are formed over the lower electrode 14 and the upper electrode 18.

As illustrated in FIG. 12D, the wiring 32 that is embedded in the through-holes 58 and is coupled to the lower electrode 14 and the upper electrode 18 is formed. The protective film 34 is formed over the insulating film 30 so as to cover the wiring 32. The hard mask layer 59 remains as it is, and becomes the coating film 80 that covers the upper electrode 18.

According to the fourth embodiment, similarly to the first embodiment, the lower electrode 14 includes the first conductive film 20 including at least one of a Ti film and a TiN film, and the second conductive film 22 provided over the upper surface of the first conductive film 20 and including Al having a (111) orientation. Consequently, the film thickness of the insulating film 16 may be stabilized, and the variation in characteristics of the Josephson device may be suppressed.

In the manufacturing method of the fourth embodiment, as illustrated in FIG. 11A, the first conductive film 20 and the second conductive film 22 are formed by using a sputtering method. As illustrated in FIG. 11B, the intermediate insulating film 50 is formed over the second conductive film 22, and then the superconducting film 52 is formed over the intermediate insulating film 50. As illustrated in FIG. 11C, the upper electrode 18 is formed by patterning the superconducting film 52 by using the resist mask layer 54 (first mask layer) formed over the superconducting film 52 as a mask. As illustrated in FIG. 12A, the insulating film 16 is formed by patterning the intermediate insulating film 50 by using, as a mask, the hard mask layer 59 (second mask layer) formed over the intermediate insulating film 50 to cover the upper electrode 18. As illustrated in FIG. 12B, the lower electrode 14 is formed by patterning the second conductive film 22 and the first conductive film 20 by using the hard mask layer 59 as a mask. Consequently, a Josephson device in which a variation in characteristics is suppressed may be easily formed.

In the fourth embodiment, the coating film 80 may not be provided. As in the second embodiment, the third conductive film 24 may be provided between the insulating film 12 and the first conductive film 20. As in the third embodiment, the second conductive film 22a made of an Al-alloy film may be provided instead of the second conductive film 22 made of an Al film. As in the modification example of the third embodiment, the second conductive film 22b may be a stacked film of the first film 23 made of an Al-alloy film and the second film 25 made of an Al film.

In the first to fourth embodiments, the shapes of the lower electrode 14 and the upper electrode 18 in plan view are not limited to the case where the upper electrode 18 having a rectangular shape overlaps a part of the lower electrode 14 having a large shape as illustrated in FIG. 1A. For example, the lower electrode 14 and the upper electrode 18 may both have a rectangular shape having a longitudinal direction in the same direction (for example, the X-axis direction), and end portions of the lower electrode 14 and the upper electrode 18 may overlap each other. One of the lower electrode 14 and the upper electrode 18 may have a rectangular shape having a longitudinal direction in the X-axis direction, and the other may have a rectangular shape having a longitudinal direction in the Y-axis direction, and the lower electrode 14 and the upper electrode 18 may intersect with each other in a cross shape. The rectangular upper electrode 18 having substantially the same size as a width of the lower electrode 14 may be provided in a central portion of the rectangular lower electrode 14.

In the first to fourth embodiments, the upper electrode 18 may be a film other than the Al film. For example, the upper electrode 18 may be a single-layer film or a stacked film of a superconducting film such as a niobium (Nb) film, a niobium nitride (NbN) film, a tantalum (Ta) film, a tantalum nitride (TaN) film, or a titanium nitride (TiN) film. The insulating film 16 may be a film other than an aluminum oxide film.

### [Fifth Embodiment]

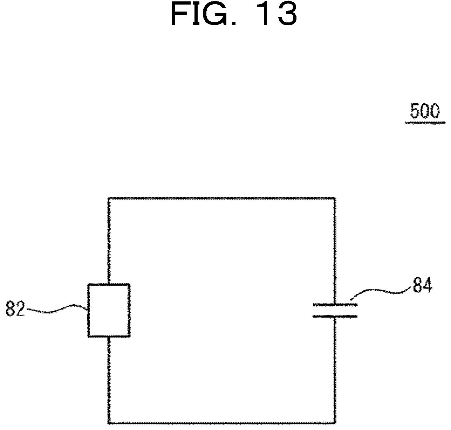

FIG. 13 is a circuit diagram of a qubit 500 according to a fifth embodiment. As illustrated in FIG. 13, the qubit 500 according to the fifth embodiment is a transmon qubit including a Josephson device 82 and a capacitor 84 coupled in parallel to the Josephson device 82. As the Josephson device 82, the Josephson devices according to any one of the first embodiment to the fourth embodiment may be used. The qubit 500 may be a magnetic flux qubit including a Josephson device.

While the embodiments of the present invention have been described in detail above, the present invention is not limited to such specific embodiments, and various modifications and alterations may be made within the scope of the present invention defined by the claims.

## Claims

1. A method for manufacturing a Josephson device (100), the method comprising:
forming a first conductive film (20) that includes at least one of a titanium film or a titanium nitride film and a second conductive film (22) that includes superconducting aluminum by using a sputtering method to form a lower electrode (14) that includes the first conductive film (20) and the second conductive film (22) provided over an upper surface of the first conductive film (20);
forming an insulating film (16) over the lower electrode (14); and
forming an upper electrode (18) that includes a superconducting material so as to have a region that overlaps the lower electrode (14) via the insulating film (16),
**characterised in that** the superconducting aluminum has a (111) orientation.

2. The method for manufacturing a Josephson device (100) according to claim 1, wherein
the first conductive film (20) is a titanium nitride film that has a (111) orientation.

3. The method for manufacturing a Josephson device (100) according to claim 1 or 2, wherein
the first conductive film (20) and the second conductive film (22) are continuously formed in vacuum.

4. The method for manufacturing a Josephson device (100) according to claim 2, wherein
in the forming the lower electrode (14), a third conductive film (24) which is a titanium film that has a (002) orientation is formed by using a sputtering method before the first conductive film (20) is formed, and the lower electrode (14) that includes the third conductive film, the first conductive film (20) provided over an upper surface of the third conductive film, and the second conductive film (22) provided over an upper surface of the first conductive film (20) is formed.

5. A Josephson device (100) comprising:
a lower electrode (14) that includes a first conductive film (20) that includes at least one of a titanium film or a titanium nitride film, and a second conductive film (22) that is provided over an upper surface of the first conductive film (20) and includes superconducting aluminum;
an insulating film (16) provided over the lower electrode (14); and
an upper electrode (18) that includes a superconducting material and is provided to have a region that overlaps the lower electrode (14) via the insulating film (16),
**characterised in that** the superconducting aluminum has a (111) orientation.

6. The Josephson device (100) according to claim 5, wherein
the first conductive film (20) is a titanium nitride film that has a (111) orientation.

7. The Josephson device (100) according to claim 6, wherein
the lower electrode (14) includes a third conductive film (24) which is a titanium
film that has an (002) orientation, and
the first conductive film (20) is provided over an upper surface of the third conductive film.

8. The Josephson device (100) according to claim 5 or 6, wherein
the second conductive film (22) includes an aluminum alloy film in which another element is added to aluminum.

9. The Josephson device (100) according to claim 5 or 6, wherein
the second conductive film (22) includes an aluminum alloy film in which another element is added to aluminum, and an aluminum film provided between the aluminum alloy film and the insulating film (16).

10. A qubit (500)
comprising a Josephson device (100) according to claim 5.

## Patentansprüche

1. Verfahren zum Herstellen einer Josephson-Vorrichtung (100), wobei das Verfahren Folgendes umfasst:
Ausbilden einer ersten leitfähigen Schicht (20), die mindestens eine von einer Titanschicht oder einer Titannitridschicht beinhaltet, und einer zweiten leitfähigen Schicht (22), die supraleitendes Aluminium beinhaltet, unter Verwendung eines Sputterverfahrens, um eine untere Elektrode (14) auszubilden, die die erste leitfähige Schicht (20) und die zweite leitfähige Schicht (22), die auf einer oberen Fläche der ersten leitfähigen Schicht (20) bereitgestellt ist, beinhaltet;
Ausbilden einer isolierenden Schicht (16) über der unteren Elektrode (14); und
Ausbilden einer oberen Elektrode (18), die ein supraleitendes Material beinhaltet, sodass sie einen Bereich aufweist, der die untere Elektrode (14) über die isolierende Schicht (16) überlappt, **dadurch gekennzeichnet, dass** das supraleitende Aluminium eine (111)-Orientierung aufweist.

2. Verfahren zum Herstellen einer Josephson-Vorrichtung (100) nach Anspruch 1, wobei
die erste leitfähige Schicht (20) eine Titannitridschicht, die eine (111)-Orientierung aufweist, ist.

3. Verfahren zum Herstellen einer Josephson-Vorrichtung (100) nach Anspruch 1 oder 2, wobei
die erste leitfähige Schicht (20) und die zweite leitfähige Schicht (22) kontinuierlich im Vakuum ausgebildet werden.

4. Verfahren zum Herstellen einer Josephson-Vorrichtung (100) nach Anspruch 2, wobei
bei dem Ausbilden der unteren Elektrode (14), bevor die erste leitfähige Schicht (20) ausgebildet wird, unter Verwendung eines Sputterverfahrens eine dritte leitfähige Schicht (24), die eine Titanschicht ist, die eine (002)-Orientierung aufweist, ausgebildet wird, und die untere Elektrode (14), die die dritte leitfähige Schicht, die erste leitfähige Schicht (20), die über einer oberen Fläche der dritten leitfähigen Schicht bereitgestellt wird, und die zweite leitfähige Schicht (22), die über einer oberen Fläche der ersten leitfähigen Schicht (20) bereitgestellt wird, beinhaltet, ausgebildet wird.

5. Josephson-Vorrichtung (100), umfassend:
eine untere Elektrode (14), die eine erste leitfähige Schicht (20), die mindestens eine von einer Titanschicht oder einer Titannitridschicht beinhaltet, und eine zweite leitfähige Schicht (22), die über einer oberen Fläche der ersten leitfähigen Schicht (20) bereitgestellt ist und supraleitendes Aluminium beinhaltet, beinhaltet;
eine isolierende Schicht (16), die über der unteren Elektrode (14) bereitgestellt ist; und
eine obere Elektrode (18), die ein supraleitendes Material beinhaltet und bereitgestellt ist, um einen Bereich aufzuweisen, der die untere Elektrode (14) über die isolierende Schicht (16) überlappt, **dadurch gekennzeichnet, dass** das supraleitende Aluminium eine (111)-Orientierung aufweist.

6. Josephson-Vorrichtung (100) nach Anspruch 5, wobei die erste leitfähige Schicht (20) eine Titannitridschicht, die eine (111)-Orientierung aufweist, ist.

7. Josephson-Vorrichtung (100) nach Anspruch 6, wobei die untere Elektrode (14) eine dritte leitfähige Schicht (24) beinhaltet, die eine Titanschicht ist, die eine (002)-Orientierung aufweist, und
die erste leitfähige Schicht (20) über einer oberen Fläche der dritten leitfähigen Schicht bereitgestellt ist.

8. Josephson-Vorrichtung (100) nach Anspruch 5 oder 6, wobei die zweite leitfähige Schicht (22) eine Aluminiumlegierungsschicht, bei der ein anderes Element zu Aluminium hinzugefügt ist, beinhaltet.

9. Josephson-Vorrichtung (100) nach Anspruch 5 oder 6, wobei die zweite leitfähige Schicht (22) eine Aluminiumlegierungsschicht, bei der ein anderes Element zu Aluminium hinzugefügt ist, beinhaltet, und eine Aluminiumschicht zwischen der Aluminiumlegierungsschicht und der isolierenden Schicht (16) bereitgestellt ist.

10. Qubit (500), das eine Josephson-Vorrichtung (100) nach Anspruch 5 umfasst.

## Revendications

1. Procédé de fabrication d'un dispositif Josephson (100), le procédé comprenant :
la formation d'un premier film conducteur (20) qui comporte au moins l'un d'un film de titane ou d'un film de nitrure de titane et d'un deuxième film conducteur (22) qui comporte de l'aluminium supraconducteur à l'aide d'un procédé de pulvérisation pour former une électrode inférieure (14) qui comporte le premier film conducteur (20) et le deuxième film conducteur (22) disposé sur une surface supérieure du premier film conducteur (20) ;
la formation d'un film isolant (16) sur l'électrode inférieure (14) ; et
la formation d'une électrode supérieure (18) qui comporte un matériau supraconducteur de manière à avoir une région qui chevauche l'électrode inférieure (14) via le film isolant (16), **caractérisé en ce que** l'aluminium supraconducteur a une orientation (111).

2. Procédé de fabrication d'un dispositif Josephson (100) selon la revendication 1, dans lequel
le premier film conducteur (20) est un film de nitrure de titane qui a une orientation (111).

3. Procédé de fabrication d'un dispositif Josephson (100) selon la revendication 1 ou 2, dans lequel
le premier film conducteur (20) et le deuxième film conducteur (22) sont formés en continu sous vide.

4. Procédé de fabrication d'un dispositif Josephson (100) selon la revendication 2, dans lequel
lors de la formation de l'électrode inférieure (14), un troisième film conducteur (24), qui est un film de titane ayant une orientation (002), est formé à l'aide d'un procédé de pulvérisation avant la formation du premier film conducteur (20), et l'électrode inférieure (14) qui comporte le troisième film conducteur, le premier film conducteur (20) disposé sur une surface supérieure du troisième film conducteur et le deuxième film conducteur (22) disposé sur une surface supérieure du premier film conducteur (20) est formée.

5. Dispositif Josephson (100) comprenant :
une électrode inférieure (14) qui comporte un premier film conducteur (20) qui comporte au moins l'un d'un film de titane ou d'un film de nitrure de titane, et un deuxième film conducteur (22) qui est disposé sur une surface supérieure du premier film conducteur (20) et qui comporte de l'aluminium supraconducteur ; un film isolant (16) disposé sur l'électrode inférieure (14) ; et
une électrode supérieure (18) qui comporte un matériau supraconducteur et qui est disposée de manière à avoir une région qui chevauche l'électrode inférieure (14) via le film isolant (16), **caractérisé en ce que** l'aluminium supraconducteur a une orientation (111).

6. Dispositif Josephson (100) selon la revendication 5, dans lequel
le premier film conducteur (20) est un film de nitrure de titane qui a une orientation (111).

7. Dispositif Josephson (100) selon la revendication 6, dans lequel
l'électrode inférieure (14) comporte un troisième film conducteur (24) qui est un film de titane ayant une orientation (002), et
le premier film conducteur (20) est disposé sur une surface supérieure du troisième film conducteur.

8. Dispositif Josephson (100) selon la revendication 5 ou 6, dans lequel
le deuxième film conducteur (22) comporte un film en alliage d'aluminium dans lequel un autre élément est ajouté à l'aluminium.

9. Dispositif Josephson (100) selon la revendication 5 ou 6, dans lequel
le deuxième film conducteur (22) comporte un film en alliage d'aluminium dans lequel un autre élément est ajouté à l'aluminium, et un film d'aluminium disposé entre le film en alliage d'aluminium et le film isolant (16).

10. Bit quantique (500) comprenant un dispositif Josephson (100) selon la revendication 5.
